# EUROPEAN PATENT SPECIFICATION

(11) **EP 2 447 993 B1**
(45) Date of publication and mention of the grant of the patent: **19.12.2018**
(21) Application number: 10809474.9
(22) Date of filing: 07.05.2010
(51) Int. Cl.: H01L 23/498, H01L 23/13, H01L 25/16

(54) **Electronic packaging structure**
Elektronische Packungsstruktur
Structrue d'emballage électronique

(30) Priority: 21.08.2009 CN 200920173223 U
(43) Date of publication of application: 02.05.2012
(73) Proprietor: Huawei Device (Dongguan) Co., Ltd., Dongguan, Guangdong, PRC, 523808 (CN)
(72) Inventor: QIAO, Jitao, Shenzhen Guangdong 518129 (CN)
(74) Representative: Thun, Clemens
(86) International application number: PCT/CN2010/072513
(87) International publication number: WO 2011/020341

(56) References cited:
- EP-A1- 1 876 642
- EP-A2- 0 862 213
- CN-A- 101 316 481
- CN-A- 101 399 261
- CN-A- 101 546 742
- JP-A- 6 140 738
- JP-A- 2002 043 710
- US-A- 5 962 917
- US-A1- 2001 040 287
- US-A1- 2002 024 130
- US-A1- 2009 085 184

## Description

### FIELD OF THE INVENTION

The present invention relates to semiconductor technologies, and in particular, to a packaging structure of an electronic module.

### BACKGROUND OF THE INVENTION

In the field of semiconductor technologies, an electronic module that is prepared in advance and used to process signals needs to be packaged onto a motherboard, for example, a printed circuit board. The types of interfaces used for packaging the electronic module and the printed circuit board generally include: land grid array (Land Grid Array, LGA for short), ball grid array (Ball Grid Array, BGA for short), and pin grid array (Pin Grid Array, PGA for short) and so on. The electronic module is electrically connected to the printed circuit board via the above types of interfaces, so as to implement communication between different electronic modules on the printed circuit board or between the electronic modules on the printed circuit board and external devices.

In the process of packaging the electronic module based on the LGA type of interface, the pad of the electronic module needs to be firmly welded with the pad on the printed circuit board. In the prior art, a pressing block with preset quality is placed on an upper surface of an electronic module to be packaged. In the process of aligned welding between the pad of the electronic module and the pad of the printed circuit board, the electronic module and the printed circuit board are pressed tightly by the pressing block, so as to prevent open soldering caused by the warpage of the electronic module from interrupting the transmission of signals between the electronic module and the printed circuit board.

In the process of implementing embodiments of the present invention, the inventor finds that in the prior art, the electronic module and the printed circuit board are packaged by using other accessories, for example, a pressing block. However, with the introduction of the pressing block, the welding energy is absorbed in the packaging process, which may cause insufficient heating of the pad and thus reduce the welding quality. European patent application EP0862213 describes a prior art example of a semiconductor package with contacts on the lateral side of the substrate.

### SUMMARY OF THE INVENTION

According to the present invention, a packaging structure according to claim 1 is provided. Advantageous additional aspects follow from the dependent claims. Subject-matter mentioned in the description but not falling under the wording of the claims does not form part of the invention and is described for illustration only.

### BRIEF DESCRIPTION OF THE DRAWINGS

In order to make the technical solution in the embodiments of the present invention or in the prior art clearer, the accompanying drawings for illustrating the embodiments of the present invention or the prior art are briefly introduced in the following. Apparently, the accompanying drawings in the following description merely some embodiments of the present invention and persons of ordinary skill in the art may further derive other drawings according to these accompanying drawings without creative efforts.
FIG. 1a is a top view of an electronic module according to a first embodiment of the present invention;
FIG. 1b is a bottom view of an electronic module according to a first embodiment of the present invention;
FIG. 2 is a left view of an electronic module according to a first embodiment of the present invention;
FIG. 3 is a top view of an electronic module according to a second embodiment of the present invention;
FIG. 4 is a left view of an electronic module according to a second embodiment of the present invention;
FIG. 5a is a top view of a packaging structure of an electronic module according to a third embodiment of the present invention;
FIG. 5b is a left view of a packaging structure of an electronic module according to a third embodiment of the present invention;
FIG. 5c is another top view of a packaging structure of an electronic module according to a third embodiment of the present invention; and
FIG. 6 is a top view of an electronic module of an electronic module according to a fourth embodiment of the present invention.

### DETAILED DESCRIPTION OF THE EMBODIMENTS

The technical solutions in the embodiments of the present invention are described clearly and completely below with reference to the accompanying drawings. However, the invention is defined by the claims.

### Embodiment 1

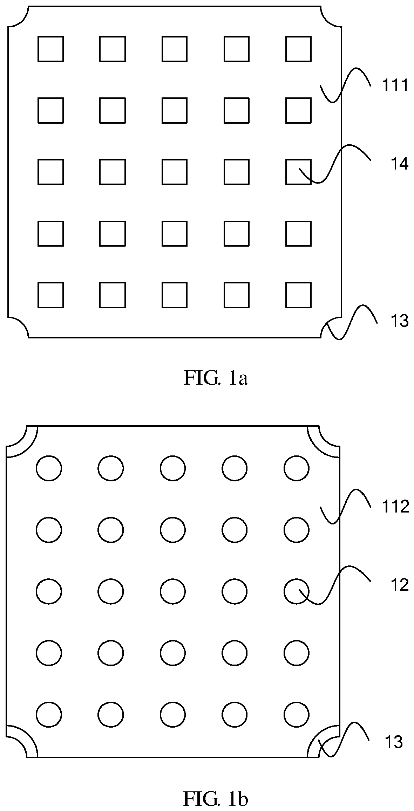

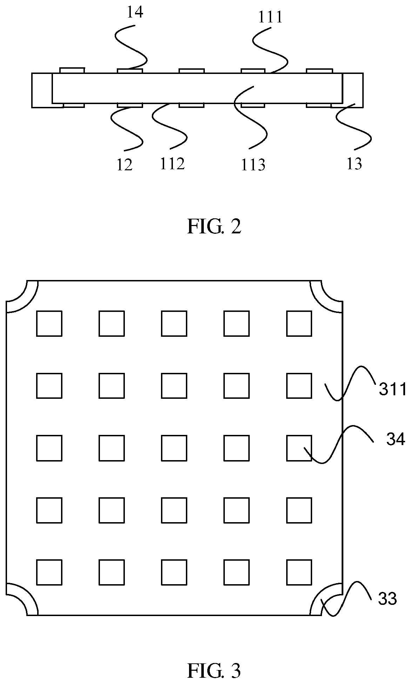

FIG. 1a is a top view of an electronic module according to a first embodiment of the present invention. FIG. 1b is a bottom view of an electronic module according to a first embodiment of the present invention. FIG. 2 is a left view of an electronic module according to a first embodiment of the present invention. As shown in FIG. 1a, FIG. 1b, and FIG. 2, the electronic module in the embodiment includes a substrate, at least one electronic component 14, and a first conductive part 12 and a second conductive part 13 configured to connect the electronic module to an external printed circuit board.

The electronic component 14 is arranged on the upper surface 111 of the substrate. The first conductive part 12 is arranged on the lower surface 112 of the substrate, and is electrically connected to the electronic component 14. The second conductive part 13 is arranged across the lateral surface 113 of the substrate and the lower surface 112 of the substrate. Through the first conductive part 12 and the second conductive part 13, the electronic module is connected to the external printed circuit board. The electronic component 14 is electrically connected to the printed circuit board through the first conductive part 12 to implement communication between the electronic module in this embodiment and other electronic modules on the printed circuit board or to implement communication between the electronic module in this embodiment and an external device via the printed circuit board. Optionally, the second conductive part 13 is electrically connected to the electronic component 14. The electronic component 14 may also be electrically connected to the printed circuit board through the second conductive part 13. The second conductive part 13 may not be electrically connected to the electronic component 14, but is merely configured to connect the electronic module to the printed circuit board, and therefore, the second conductive part 13 may also not be a conductor but is merely a connecting part. The connecting part is called a second connecting part here. The second connecting part may contact the solder on the printed circuit board, and the second connective part is welded with the solder by heating and melting the solder.

In this embodiment, when the electronic module and the printed circuit board are packaged, the lower surface 112 of the substrate in the electronic module fits the connecting surface of the printed circuit board. The first conductive part 12 in the electronic module is connected to the corresponding connecting part arranged on the printed circuit board, so that signal transmission is established between the electronic component 14 in the electronic module and the printed circuit board. The first conductive part 12 in the electronic module is not only configured to transmit signals between the electronic component 14 and the printed circuit board, but also configured to package the electronic module and the printed circuit board. The second conductive part 13 contacts the corresponding solder arranged on the printed circuit board. The solder is heated and melted. Firstly, the melted solder covers the material of the second conductive part 13 arranged on the lower surface 112 of the substrate; secondly, the melted solder is welted along the material of the second conductive part 13 arranged on the lower surface 112 of the substrate into the material of the second conductive part 13 arranged at the lateral surface 113 of the substrate. Finally, the solder that is arranged on the printed circuit board and used to connect the second conductive part 13 covers the second conductive part 13 that is arranged across the lower surface 112 of the substrate and the lateral surface 113 of the substrate, so that the lower surface 112 of the substrate and the lateral surface 113 of the substrate are connected to the printed circuit board.

In this embodiment, a second conductive part is arranged in the electronic module, and two sides of the substrate in the electronic module are welded with the printed circuit board in the process of packaging the electronic module and the printed circuit board. In this way, the possibility of open soldering caused by the warpage of the electronic module is reduced, and the electronic module and the printed circuit board are firmly packaged, which helps to establish a good connection between the first conductive part and the printed circuit board. Therefore, the quality of welding between the electronic module in this embodiment and the printed circuit board is improved. In the prior art, in order to increase the mechanical strength after the electronic module and the printed circuit board are packaged, several pads connected to the solder of the printed circuit board are generally added around the substrate of the electronic module. However, the added pads may enlarge the area of the electronic module. Compared with the prior art, a second conductive part is arranged in the electronic module in this embodiment, so that two sides of the electronic module are connected to the printed circuit board, which effectively increases the mechanical strength after the electronic module and the printed circuit board are packaged.

On the basis of the above technical solution, optionally, a second conductive part 13 is formed at the four corners of the substrate. In the electronic module in this embodiment, a square substrate is taken as an example, and the substrates of other shapes are also within the protection scope of the present invention. In this embodiment, Four second conductive parts 13 are formed at the four corners of the substrate of the electronic module. The second conductive part 13 may be arranged across the lower surface 112 of the substrate and the lateral surface 113 of the substrate.

In this embodiment, the electronic module forms four second conductive parts at the four corners of the substrate, so that the four corners of the electronic module are firmly packaged with the printed circuit board; after the electronic module and the printed circuit board are packaged, the first conductive part is well connected to the printed circuit board. Therefore, the quality of the welding between the electronic module and the printed circuit board is improved. In addition, in this embodiment, a second conductive part is formed at the four corners, so that the four corners of the electronic module are firmly welded with the printed circuit board, which increases the mechanical strength after the electronic module and the printed circuit board are packaged.

On the basis of the above technical solution, optionally, the first conductive part 12 is a pad, a solder ball, or a pin. When the first conductive part 12 is a pad, the electronic module and the printed circuit board are packaged in LGA mode. When the first conductive part 12 is a solder ball, the electronic module and the printed circuit board are packaged in BGA mode. When the first conductive part 12 is a pin, the electronic module and the printed circuit board are packaged in PGA mode.

In the electronic module in this embodiment, the first conductive part is a pin, so that the electronic module is applicable to such packaging modes as PGA, and then the electronic module in this embodiment and the printed circuit board may be packaged in LGA, BGA, or PGA mode, thus extending the selection scope of the packaging modes for the electronic module and improving the flexibility of the packaging between the electronic module in this embodiment and the printed circuit board.

That the electronic module in this embodiment and the printed circuit board are packaged in LGA mode is taken as an example, so as to illustrate the process of packaging the electronic module in this embodiment and the printed circuit board. In the electronic module that is packaged in LGA mode, the first conductive part 12 is a pad, and a pad is also arranged on the printed circuit board correspondingly. In the process of packaging the electronic module in this embodiment and the printed circuit board, the pad on the electronic module is correspondingly welded with the pad on the printed circuit board. The pad on the electronic module is not only configured to transmit signals between the electronic component and the printed circuit board, but also configured to package the electronic module and the printed circuit board. The second conductive part 13 in the electronic module correspondingly contacts the solder on the printed circuit board; after the solder is heated and melted, the melted solder on the printed circuit board may connect the lower surface 112 and lateral surface 113 of the substrate in the electronic module to the printed circuit board along the second conductive part 13, so that two sides of the electronic module are firmly welded with the printed circuit board. In the practical application of the electronic module in this embodiment, two sides of the electronic module are firmly welded with the printed circuit board, so that the pad of the electronic module is closely connected to the pad of the printed circuit board, thereby improving the quality of welding between the electronic module and the printed circuit board.

### Illustrative Embodiment 2 (not part of the invention)

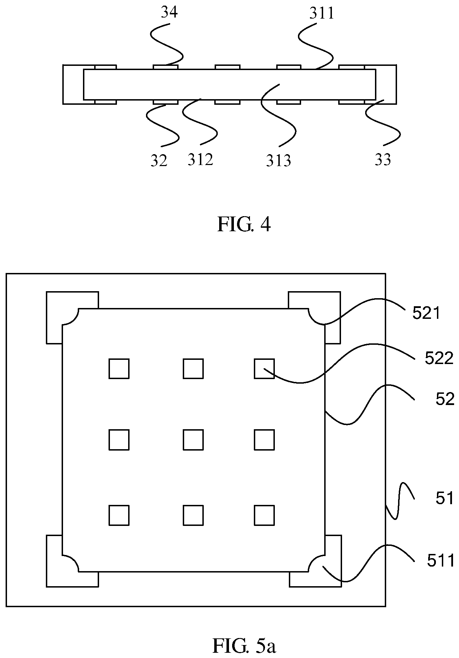

FIG. 3 is a top view of an electronic module according to a second embodiment of the present invention. FIG. 4 is a left view of an electronic module according to a second embodiment of the present invention. As shown in FIG. 3 and FIG. 4, the electronic module in the second embodiment is based on the first embodiment, and is different from the electronic module in the first embodiment in that a second conductive part 33 may further be arranged across the upper surface 311 of the substrate. In the process of packaging the electronic module and the printed circuit board, after the solder on the printed circuit board is melted, the welted solder welds the second conductive part 33 with the solder along the second conductive part 33, so that a lower surface 312, a lateral surface 313, and an upper surface 311 of the substrate in the electronic module are welded with the printed circuit board, thereby implementing that three sides of the electronic module are firmly connected to the circuit printed board.

In the electronic module in this embodiment, the second conductive part 33 is arranged across the three sides of the substrate, so that the electronic module is packaged with the printed circuit board more firmly, which better improves the quality of welding between the electronic module and the printed circuit board. Meanwhile, the three sides of the electronic module in this embodiment are connected to the printed circuit board, which increases the mechanical strength more effectively after the electronic module and the printed circuit board are packaged.

On the basis of the above technical solution, optionally, the second conductive part 33 is located at any area of the substrate other than the area of the first conductive part 32. In the electronic module in this embodiment, the second conductive part 33 may be arranged at any area of the substrate other than the area of the first conductive part 32. For example, a through-hole may be arranged at any area of the substrate other than the area of the first conductive part 32, and then the second conductive part 33 is arranged across the wall of the through-hole and the lower surface 312 and the upper surface 311 of the substrate.

In the electronic module in this embodiment, the second conductive part is arranged at any area of the substrate other than the area of the first conductive part; in the process of packaging the electronic module and the printed circuit board, the second conductive part may be arranged at any specified position in the center area or four corners of the substrate of the electronic module according to the requirements for packaging the electronic module and the printed circuit board, so that the electronic module and the printed circuit board are packaged more firmly, which improves the quality of welding between the electronic module and the printed circuit board, and increases the mechanical strength after the electronic module and the printed circuit board are packaged.

On the basis of the above technical solution, optionally, the second conductive part 33 is electrically connected to an electronic component 34. In the process of packaging the electronic module and the printed circuit board, the second conductive part 33 is not only configured to package the electronic module and the printed circuit board, but also configured to electrically connect to the electronic component 34. Signal transmission is established between the electronic component 34 and the printed circuit board through the second conductive part 33.

The electronic module in this embodiment is electrically connected to the electronic component through the second conductive part, so that the second conductive part can transmit signals. Therefore, the second conductive part of the electronic module is effectively utilized, which helps to reduce the area of the electronic module.

### Embodiment 3

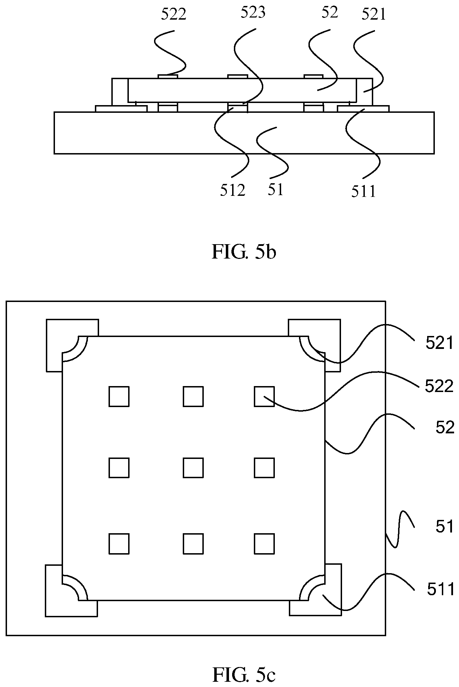

FIG. 5a is a top view of a packaging structure of an electronic module according to a third embodiment of the present invention. FIG. 5b is a left view of a packaging structure of an electronic module according to a third embodiment of the present invention. In this embodiment, the packaging structure of the electronic module includes: at least one electronic module and a printed circuit board. In this embodiment, that one electronic module is arranged on the printed circuit board is taken as an example in the packaging structure of the electronic module. As shown in FIG. 5a and FIG. 5b, the packaging structure of the electronic module in this embodiment includes one electronic module 52 and a printed circuit board 51.

The electronic module 52 includes: a substrate; at least one electronic component 522, arranged on the upper surface of the substrate; a first conductive part 523, arranged on the lower surface of the substrate and electrically connected to the electronic component 522; and a second conductive part 521, arranged across the lateral surface of the substrate and the lower surface of the substrate.

The printed circuit board 51 is packaged with the electronic module 52 through the first conductive part 523 and the second conductive part 521.

On the basis of the above technical solution, the first conductive part 523 is a pin. When the first conductive part 523 is a pad, a pad is arranged at a packaging position on the printed circuit board 51 corresponding to the electronic module 52. By welding the pad of the electronic module 52 with the pad of the printed circuit board 51, the electronic module 52 and the printed circuit board 51 in the packaging structure of the electronic module in this embodiment are packaged in LGA mode. When the first conductive part 523 is a solder ball, a welding area is arranged at a packaging position on the printed circuit board 51 corresponding to the electronic module 52. By welding the solder ball of the electronic module 52 with the welding area of the printed circuit board, the electronic module 52 and the printed circuit board 51 in the packaging structure of the electronic module in this embodiment are packaged in BGA mode. When the first conductive part 523 is a pin, a slot is arranged at a packaging position on the printed circuit board 51 corresponding to the electronic module 52. By inserting the pin of the electronic module 52 into the slot of the printed circuit board 51, the electronic module 52 and the printed circuit board 51 in the packaging structure of the electronic module in this embodiment are packaged in PGA mode.

That one electronic module is packaged on the printed circuit board is taken as an example in the packaging structure of the electronic module in this embodiment, so as to further illustrate the packaging structure of the electronic module in this embodiment. In the process of packaging the electronic module 52 and the printed circuit board 51, the first conductive part 523 of the electronic module 52 is connected to a corresponding first connecting part 512 arranged on the printed circuit board 51, so that signal transmission is established between the electronic component 522 of the electronic module 52 and the printed circuit board. The first conductive part 523 of the electronic module 52 is not only configured to transmit signals between the electronic component 522 and the printed circuit board 51, but also configured to package the electronic module 52 and the printed circuit board 51. The second conductive part 521 contacts a corresponding solder 511 arranged on the printed circuit board 51. The solder 511 is heated and melted. The melted solder 51 covers the second conductive part 521 that is arranged across the lower surface and lateral surface of the substrate in the electronic module 52, so that the lower surface and lateral surface of the substrate of the electronic module 52 are connected to the printed circuit board 51. The first connecting part 512 may be the foregoing slot.

In the packaging structure of the electronic module in this embodiment, a second conductive part is arranged; two sides of the substrate in the electronic module are welded with the printed circuit board in the process of packaging the electronic module and the printed circuit board, so that the possibility of open soldering due to the warpage of the electronic module is reduced, and the electronic module and the printed circuit board are firmly packaged, which helps to establish a good connection between the first conductive part and the printed circuit board. Therefore, the welding quality of the packaging structure of the electronic module in this embodiment is improved. In the packaging structure of the electronic module in this embodiment, a second conductive part is arranged, and two sides of the electronic module are connected to the printed circuit board, which effectively increases the mechanical strength of the packaging structure of the electronic module. In addition, in the packaging structure of the electronic module in this embodiment, the first conductive part is a pin, and the electronic module in this embodiment and the printed circuit board in the packaging structure of the electronic module may be packaged in PGA mode, and thus extending the selection scope of the packaging modes for the packaging structure of the electronic module in this embodiment and improving the packaging flexibility of the packaging structure of the electronic module.

On the basis of the above technical solution, referring to FIG. 5c, FIG. 5c is another top view of a packaging structure of an electronic module according to a third embodiment of the present invention. Optionally, the second conductive part 521 may also be arranged across the upper surface of the substrate. In the packaging structure of the electronic module in this embodiment, after the solder 511 on the printed circuit board 51 is melted, the melted solder 511 connects the lower surface, the lateral surface, and the upper surface of the substrate in the electronic module 52 to the printed circuit board 51 along the second conductive part 521, thereby implementing that three sides of the electronic module 52 are firmly connected to the printed circuit board 51.

In the packaging structure of the electronic module in this embodiment, the second conductive part is arranged across the three sides of the substrate, so that the electronic module and the printed circuit board in the packaging structure of the electronic module are packaged more firmly, which better improves the welding quality of the packaging structure of the electronic module in this embodiment. Meanwhile, in the packaging structure of the electronic module in this embodiment, three sides of the electronic module are connected to the printed circuit board, which increases the mechanical strength of the packaging structure of the electronic module more effectively.

On the basis of the above technical solution, optionally, the second conductive part 521 is formed at the four corners of the substrate. In the packaging structure of the electronic module in this embodiment, the substrate of the electronic module 52 may be designed in a square structure, but substrates in other shapes or structures also fall within the scope of the present invention. In the packaging structure of the electronic module in this embodiment, a second conductive part 521 is formed at the four corners of the substrate of the electronic module 52, where the second conductive part 521 may be arranged across the lower surface and lateral surface of the substrate or across the lower surface, lateral surface, and upper surface of the substrate. Or, optionally, the second conductive part 521 is located at any area of the substrate other than the area of the first conductive part 523. In the packaging structure of the electronic module in this embodiment, the second conductive part 521 may be arranged at any area of the substrate other than the area of the first conductive part 523. For example, a through-hole may be arranged at any area of the substrate other than the area of the first conductive part 523, and then the second conductive part 521 is arranged across the wall of the through-hole and the lower surface and the upper surface of the substrate.

In the packaging structure of the electronic module in this embodiment, the second conductive part is formed at the four corners of the substrate, so that the four corners of the electronic module are firmly packaged with the printed circuit board; after the electronic module and the printed circuit board are packaged, the first conductive part is well connected to the printed circuit board, which improves the welding quality of the packaging structure of the electronic module. In addition, in the packaging structure of the electronic module in this embodiment, the second conductive part is formed at the four corners of the electronic module, which increases the mechanical strength of the packaging structure of the electronic module. The second conductive part is arranged at any area of the substrate other than the area of the first conductive part; in the packaging structure of the electronic module, a second conductive part may be arranged at any specified position in the center area or four corners of the substrate of the electronic module according to the requirements for packaging the electronic module and the printed circuit board, so that the electronic module is packaged with the printed circuit board more firmly, which improves the welding quality and increases mechanical strength of the packaging structure of the electronic module in this embodiment.

On the basis of the above technical solution, optionally, the second conductive part 521 is electrically connected to an electronic component 522. In the packaging structure of the electronic module, the second conductive part 521 is not only configured to weld and package the electronic module 52 with the printed circuit board 51, but also configured to electrically connect to the electronic component 522. Signal transmission is established between the electronic component 522 and the printed circuit board 51 through the second conductive part 521.

In the packaging structure of the electronic module in this embodiment, the second conductive part is electrically connected to the electronic component, so that the second conductive part can transmit signals. Therefore, the second conductive part of the packaging structure of the electronic module is effectively utilized, which helps to reduce the area of the packaging structure of the electronic module.

### Embodiment 4

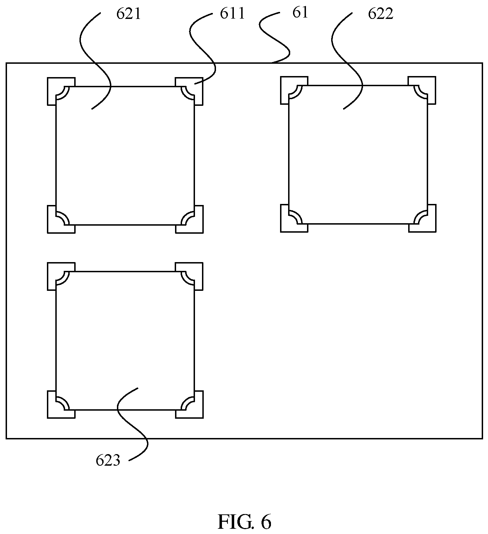

FIG. 6 is a top view of a packaging structure of an electronic module according to a fourth embodiment of the present invention. The packaging structure of the electronic module in this embodiment is based on the third embodiment, and is different from the packaging structure of the electronic module in the third embodiment in that the packaging structure of the electronic module in this embodiment includes multiple electronic modules. For example, the packaging structure of the electronic module in this embodiment includes three electronic modules, where the three electronic modules may be packaged with the printed circuit board in the same packaging mode. For example, the three electronic modules are packaged with the printed circuit board in LGA, BGA, or PGA packaging mode; or the three electronic modules are packaged with the printed circuit board in at least two packaging modes, for example, in LGA and BGA modes, in LGA and PGA modes, or in BGA and PGA modes, or in LGA, PGA, and BGA modes. The following describes that the three electronic modules are packaged in LGA, PGA and BGA modes respectively, so as to illustrate the packaging structure of the electronic module in this embodiment. As shown in FIG. 6, in the packaging structure of the electronic module in this embodiment, a first electronic module 621 is packaged in LGA mode; a second electronic module 622 is packaged in BGA mode; and a third electronic module 623 is packaged in PGA mode. A first conductive part in the first electronic module 621 is a pad; a pad is arranged at a packaging position on the printed circuit board 61 corresponding to the first electronic module 621; and the pad of the printed circuit board 61 is correspondingly welded with the pad of the first electronic module 621. A first conductive part in the second electronic module 622 is a solder ball; a welding area is arranged at a packaging position on the printed circuit board 61 corresponding to the second electronic module 622; and the welding area of the printed circuit board 61 is correspondingly welded with the solder ball of the second electronic module 622. A first conductive part in the third electronic module 623 is a pin; a slot is arranged at a packaging position on the printed circuit board 61 corresponding to the third electronic module 623; and the slot of the printed circuit board 61 is correspondingly connected to the pin of the third electronic module 623. The first electronic module 621, the second electronic module 622, and the third electronic module 623 are welded with the solder 611 of the printed circuit board 61 respectively through the second conductive part. In the packaging structure of the electronic module in this embodiment, the second conductive part may be the second conductive part in the foregoing embodiment, and is not further described here.

In the packaging structure of the electronic module in this embodiment, multiple electronic modules may be arranged on the printed circuit board according to the actual needs. The packaging structure of the electronic module in this embodiment does not limit the number of electronic modules.

In the packaging structure of the electronic module in this embodiment, multiple electronic modules that are packaged in the same mode are arranged on the same printed circuit board, or multiple electronic modules that are packaged in different modes are arranged on the same printed circuit board, so that the printed circuit board in the packaging structure of the electronic module in this embodiment may be packaged with multiple electronic modules. Meanwhile, each electronic module may be packaged with the printed circuit board in the same or different modes, and thus extending the selection scope of the packaging modes for the packaging structure of the electronic module and improving the flexibility of the packaging structure of the electronic module in this embodiment.

## Claims

1. A packaging structure of an electronic module, comprising:
at least one electronic module, wherein the electronic module comprises: a substrate; at least one electronic component (14), arranged on an upper surface (111) of the substrate; a first conductive part (12, 523), arranged on a lower surface (112) of the substrate and electrically connected to the electronic component; and a second connecting part (13), arranged on a lateral surface of the substrate and the lower surface of the substrate; and
a printed circuit board, packaged with the electronic module through the first conductive part and the second connecting part,
**characterized in that**
the first conductive part (12) is a pin and a slot is arranged at a packaging position on the printed circuit board corresponding to a position of the pin of the electronic module.

2. The packaging structure of the electronic module according to claim 1, wherein:
the second connecting part (13) is formed at four corners of the substrate; or
the second connecting part (13) is located at any area of the substrate other than an area of the first conductive part.

3. The packaging structure of the electronic module according to claim 2, wherein:
the second connecting part (13) is a second conductive part, wherein the second conductive part is electrically connected to the electronic component.

## Patentansprüche

1. Kapselungsstruktur eines elektronischen Moduls, die Folgendes umfasst:
wenigstens ein elektronisches Modul, wobei das elektronische Modul Folgendes umfasst: ein Substrat; wenigstens eine elektronische Komponente (14), die auf einer oberen Oberfläche (111) des Substrats angeordnet ist; einen ersten leitfähigen Teil (12, 523), der auf einer unteren Oberfläche (112) des Substrats angeordnet ist und elektrisch mit der elektronischen Komponente verbunden ist; und einen zweiten Verbindungsteil (13), der auf einer lateralen Oberfläche des Substrats und der unteren Oberfläche des Substrats angeordnet ist; und
eine Leiterplatte, die mit dem elektronischen Modul durch den ersten leitfähigen Teil und den zweiten leitfähigen Teil gekapselt ist,
**dadurch gekennzeichnet, dass**
der erste leitfähige Teil (12) ein Stift ist und ein Einsteckplatz bei einer Kapselungsposition auf der Leiterplatte, die einer Position des Stifts des elektronischen Moduls entspricht, angeordnet ist.

2. Kapselungsstruktur des elektronischen Moduls nach Anspruch 1, wobei:
der zweite Verbindungsteil (13) an vier Ecken des Substrats gebildet ist; oder
sich der zweite Verbindungsteil (13) bei einem beliebigen Bereich des Substrats außer einem Bereich des ersten leitfähigen Teils befindet.

3. Kapselungsstruktur des elektronischen Moduls nach Anspruch 2, wobei:
der zweite Verbindungsteil (13) ein zweiter leitfähiger Teil ist, wobei der zweite leitfähige Teil elektrisch mit der elektronischen Komponente verbunden ist.

## Revendications

1. Structure de conditionnement d'un module électronique, comprenant :
au moins un module électronique, dans laquelle le module électronique comprend : un substrat ; au moins un composant électronique (14), disposé sur une surface supérieure (111) du substrat ; une première partie conductrice (12, 523), disposée sur une surface inférieure (112) du substrat et raccordée électriquement au composant électronique ; et une seconde partie de raccordement (13), disposée sur une surface latérale du substrat et sur la surface inférieure du substrat ; et
une carte de circuit imprimé, conditionnée avec le module électronique à travers la première partie conductrice et la seconde partie de raccordement,
**caractérisée en ce que**
la première partie conductrice (12) est une broche et une fente est ménagée à une position de conditionnement sur la carte de circuit imprimé correspondant à une position de la broche du module électronique.

2. Structure de conditionnement du module électronique selon la revendication 1, dans laquelle :
la seconde partie de raccordement (13) est formée aux quatre coins du substrat ; ou
la seconde partie de raccordement (13) est située à n'importe quelle zone du substrat autre qu'une zone de la première partie conductrice.

3. Structure de conditionnement du module électronique selon la revendication 2, dans laquelle :
la seconde partie de raccordement (13) est une seconde partie conductrice, dans laquelle la seconde partie conductrice est raccordée électriquement au composant électronique.
